(19) Europäisches Patentamt
European Patent Office
Office européen des brevets

(11) EP 0 523 798 B1

(12) **EUROPEAN PATENT SPECIFICATION**

(45) Date of publication and mention
of the grant of the patent:
**18.12.1996  Bulletin 1996/51**

(51) Int Cl.6: **G01K 7/00**, G01K 7/22,
G01K 3/14

(21) Application number: **92202109.2**

(22) Date of filing: **10.07.1992**

(54) **A temperature sensing device and a temperature sensing circuit using such a device**

Temperaturfühlvorrichtung und Temperaturfühlschaltung, die solche Vorrichtung benutzt

Dispositif détecteur de température et circuit détecteur de température utilisant un tel dispositif

(84) Designated Contracting States:
**DE FR GB IT NL**

(30) Priority: **19.07.1991  GB 9115694**

(43) Date of publication of application:
**20.01.1993  Bulletin 1993/03**

(73) Proprietors:
• **PHILIPS ELECTRONICS UK LIMITED**
**Croydon CR9 3QR (GB)**
Designated Contracting States:
**GB**
• **Philips Electronics N.V.**
**5621 BA Eindhoven (NL)**
Designated Contracting States:
**DE FR IT NL**

(72) Inventor: **Kelly, Brendan Patrick,**
**c/o Philips Hazel Grove**
**Stockport, Cheshire SK7 5BJ (GB)**

(74) Representative: **Stevens, Brian Thomas et al**
**Philips Electronics UK Limited**
**Patents and Trade Marks Department**
**Cross Oak Lane**
**Redhill, Surrey RH1 5HA (GB)**

(56) References cited:
EP-A- 0 174 686        EP-A- 0 369 530
EP-A- 0 409 635        US-A- 4 092 662

• PATENT ABSTRACTS OF JAPAN vol. 7, no. 138
(P-204)16 June 1983 & JP-A-58 053 730
• IEE PROCEEDINGS I. SOLID- STATE &
ELECTRON DEVICES vol. 135, no. 4, August
1988, STEVENAGE GB pages 91 - 93 M.A.
ABDALA E.A. 'OUTPUT CHARATERISTIC
STABILISATION OF POWER MOSFETS'

## Description

This invention relates to a temperature sensing device and a temperature sensing circuit using such a device.

Temperature sensing devices have previously been proposed which use a semiconductor device in the form of a diffused resistor formed by diffusing into a semiconductor body of one conductivity type impurities of the opposite conductivity type providing first and second electrodes spaced-apart on the diffused region so that the diffused region provides a resistive path between the first and second electrodes. Such diffused resistors have a positive temperature coefficient of resistance, that is their resistance increases with temperature and can thus be used to sense temperature.

US Patent No. 4092662 describes a temperature sensitive resistor in which the temperature coefficient of resistance is selected by selecting the doping of the diffused resistor. The diffused resistor is formed in an isolation well and one of the resistor electrodes is electrically shorted to the isolation well. Several of these resistors may be connected in series to enable control of the voltage coefficients of resistance.

EP-A-369530 (PHB33507) describes an example of a temperature sensing circuit in which the voltage across a diffused resistor temperature sensing device is compared with that across a second temperature sensing device having a negative temperature coefficient of resistance, for example a diode, to provide a more accurate indication of the sensed temperature.

Diffused resistors do however tend to have a temperature coefficient of resistance which varies significantly with temperature. In particular, the temperature coefficient of resistance of a diffused resistor tends to fall or decrease with temperature, that is the increase in resistance with temperature becomes smaller at higher temperatures, which can present problems and lead to less accurate temperature sensing in some applications.

According to the present invention, there is provided a temperature sensing device comprising a semiconductor body having a first region of one conductivity type adjacent one major surface within which is formed a semiconductor device having a resistance which varies with temperature, characterised in that the semiconductor diode comprises a second region of the opposite conductivity type formed within the first region and a third region of the one conductivity type formed within the second region, first and second electrodes spaced apart on the third region so that a resistive path is provided by the third region between the first and second electrodes and a reference electrode for connecting the second region to a reference potential, the impurity concentrations within the second and third regions being such that the temperature coefficients of resistance of the diffused resistor formed by the third region and the junction field effect transistor like structure formed by the second and third regions counteract to provide the semiconductor device with a temperature coefficient of resistance which changes with absolute temperature so that the relative temperature coefficient of resistance referred to the sensed temperature is substantially constant.

In a temperature sensing device in accordance with the invention, the impurity concentrations within the second and third regions are such that the temperature dependence of the resistance of the diffused resistor formed by the third region and of the junction field effect transistor like structure formed by the second and third regions counteract to provide the semiconductor device with a temperature coefficient of resistance which changes, generally increases or falls only slightly, with absolute temperature such that the relative temperature coefficient of resistance referred to the sensed temperature is substantially constant.

In contrast, a conventional diffused resistor which has a temperature coefficient of resistance which falls or decreases significantly with temperature. As the relative temperature coefficient, that is the temperature coefficient referred to the sensed temperature, of a temperature sensing device in accordance with the invention is substantially constant, more accurate temperature sensing should be possible.

The second region may have a surface impurity concentration in the region of 10 to $13 \times 10^{12}$ atoms $cm^{-2}$ and the third region may have a surface impurity concentration in the region of 2 to $3 \times 10^{12}$ atoms $cm^{-2}$. Typically the second region may have a surface impurity concentration surface of $13 \times 10^{12}$ atoms $cm^{-2}$ and the third region may have a impurity concentration of $2.3 \times 10^{12}$ atoms $cm^{-2}$. The second region may have a depth of about $2\mu m$ and the third region a depth of about 0.3 to $0.4\mu m$.

A temperature sensing circuit in accordance with the invention for sensing the temperature of an active semiconductor device may comprise at least one temperature sensing device provided at a first position adjacent the active semiconductor device, at least one other temperature sensing device provided at a second position remote from the active semiconductor device and means responsive to the temperature sensing devices for providing a control signal to switch of the active semiconductor device when the difference in the temperature sensed by the at least two temperature sensing devices exceeds a predetermined value.

A temperature sensing circuit in accordance with the invention thus provides respective temperature sensing devices one close to, and the other further from, the active device so enabling the temperature difference between the two temperature sensing devices to be determined. In certain conditions in active semiconductor devices such as power MOSFETs, for example, where a low resistance (say about $100m\Omega$), load is connected between ground and the active semiconductor device, the temperature at the centre of the active semiconductor device rises much more quickly than that of the surrounding semiconductor body so that a steep temperature gradient occurs at the periphery of the active semiconductor device. A temperature sensing circuit in accordance with the invention allows this steep temperature gradient to be detected and to be used to provide a signal to switch off the active semiconductor device before it overheats significantly. Accordingly, excessive temperatures can be detected quickly and the circuit can be particularly sensitive to temperature changes.

Furthermore, because temperature sensing devices in accordance with the invention have an effective temperature coefficient of resistance which changes with temperature so that their relative temperature coefficient of resistance remains substantially constant, the predetermined value or critical differential temperature should remain substantially constant regardless of the initial absolute temperature and accordingly the circuit will maintain a substantially constant sensitivity to differential temperature regardless of the actual temperatures sensed. This contrasts to the situation where diffused resistor temperature sensing devices are used in such a circuit where the differential temperature at which the circuit trips, that is the predetermined value, will actually fall with temperature.

In one example of a temperature sensing circuit in accordance with the invention for sensing the temperature of an active semiconductor device first and second temperature sensing devices are provided at a first position adjacent the active semiconductor device and third and fourth temperature sensing devices are provided at a second position remote from the active semiconductor device, the temperature sensing devices being connected in a Wheatstone bridge with the first and third devices and the second and fourth devices, respectively, connected in series between first and second supply lines and with the second and third devices connected to the first supply line and the means for comparing a first signal representing the voltage at a first junction between the third and first devices and a second signal representing the voltage at a second junction between the second and fourth devices and for providing an output signal which provides the control signal to switch off the active semiconductor device when the difference between the first and second voltage signals represents a temperature difference of the predetermined value.

Such a Wheatstone bridge arrangement makes the circuit more sensitive as the difference signal being detected is amplified because the increase in temperature and thus resistance of the first and second temperature sensitive devices acts to increase the voltage at the first junction whereas the similar increase in temperature experienced by the third and fourth temperature sensitive devices acts to reduce the voltage at the second junction.

The temperature sensing circuit may further comprise a transistor having its main current path connected between the first junction and the first element and another transistor having its main current path connected between the second junction and the fourth element with the gates of the transistors being connected to one another and to one of the first and second junctions. The incorporation of the current-mirror connected transistors should enable a larger differential gain which results in a lower accuracy requirement for the comparing means. Also, because this arrangement should have a higher sensitivity, it may be particularly useful where the elements have a smaller temperature coefficient of resistance or a higher noise margin.

Conveniently, means are provided for preventing the active semiconductor device from being switched on again until the temperature difference has fallen to a second predetermined value below the predetermined value. Such an arrangement introduces a hysteresis into the circuit and thus prevents the circuit from repeatedly switching the active semiconductor device on and off for small changes in temperature.

Embodiments of the invention will now be described, by way of example, with reference to the accompanying drawings, in which:

Figure 1 is a cross-sectional view through part of a semiconductor body illustrating a temperature sensing device in accordance with the invention;
Figures 2 and 3 are graphs for illustrating the relationship between temperature and the temperature coefficient of resistance of a temperature sensing device in accordance with the invention;
Figure 4 shows a circuit diagram for one embodiment of a differential temperature sensing circuit in accordance with the invention;
Figure 5 is a cross-sectional view through part of a semiconductor body in which the circuit shown in Figure 4 is formed for illustrating the structure of various components;
Figure 6 illustrates graphically a typical temperature profile from the centre to the periphery of a power MOSFET;
Figure 7 is a plan view of the semiconductor body shown in part in Figure 5 for illustrating very schematically possible relative locations of an active semiconductor and temperature sensing devices; and
Figure 8 illustrates a circuit diagram for a modified version of the differential temperature sensing circuit shown in Figure 4.

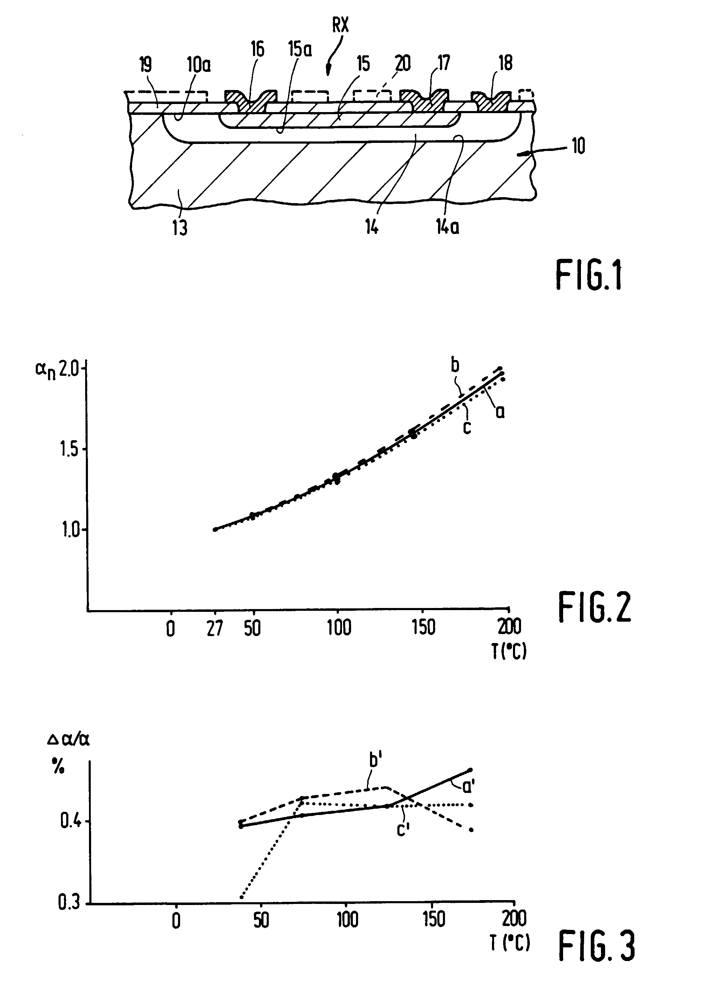

It should be understood that Figures 1,5 and 7 are merely schematic and are not drawn to scale. In particular certain dimensions such as the thickness of layers or regions may have been exaggerated whilst other dimensions may have been reduced. It should also be understood that the same reference numerals are used throughout the Figures to indicate the same or similar parts.

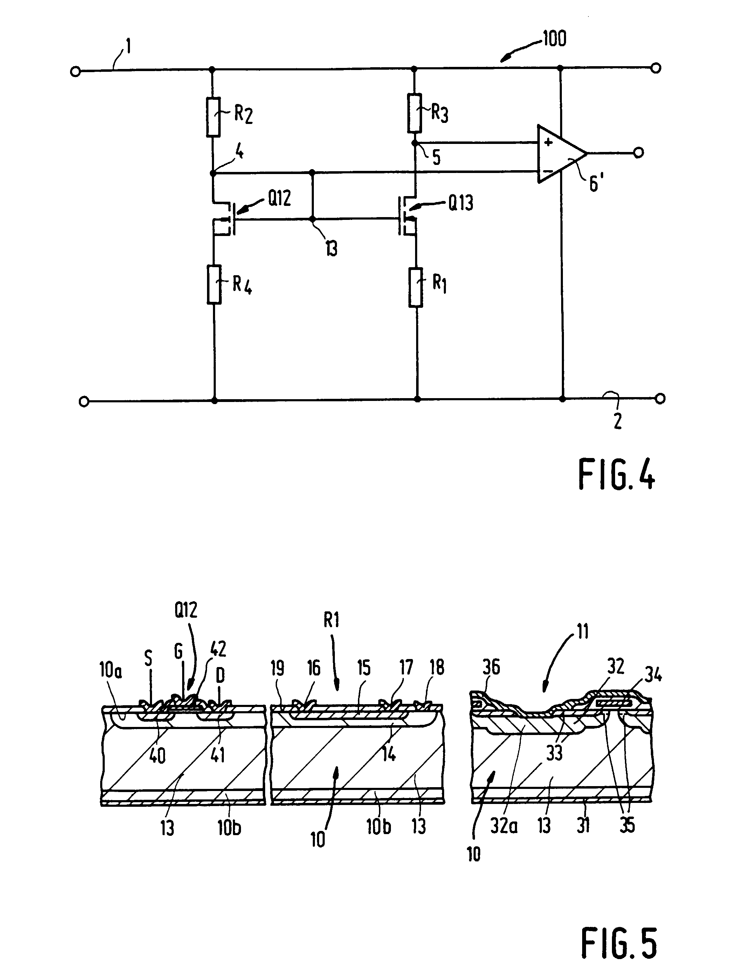

Referring now to the drawings especially Figures 1 and 4, there is illustrated a temperature sensing device comprising a semiconductor body 10 having a first region 13 of one conductivity type adjacent one major surface 10a within which is formed a semiconductor device RX having a resistance which varies with temperature. The semiconductor device RX comprises a second region 14 of the opposite conductivity type formed within the first region 13 and a third region 15 of the one conductivity type formed within the second region 14, first and second electrodes 16 and 17 spaced apart on the third region 15 so that a resistive path is provided by the third region 15 between the first and second electrodes 16 and 17 and a reference electrode 18 for connecting the second region 14 to a reference potential, the impurity concentrations within the second and third regions 14 and 15 being such that the temperature coefficients of resistance of the diffused resistor formed by the third region 15 and the junction field effect transistor like structure formed by the second and third regions 14 and 15 counteract to provide the semiconductor device RX with a temperature coefficient of resistance $\alpha$ which changes with absolute temperature such that the relative temperature coefficient of resistance referred to the sensed temperature is substantially constant.

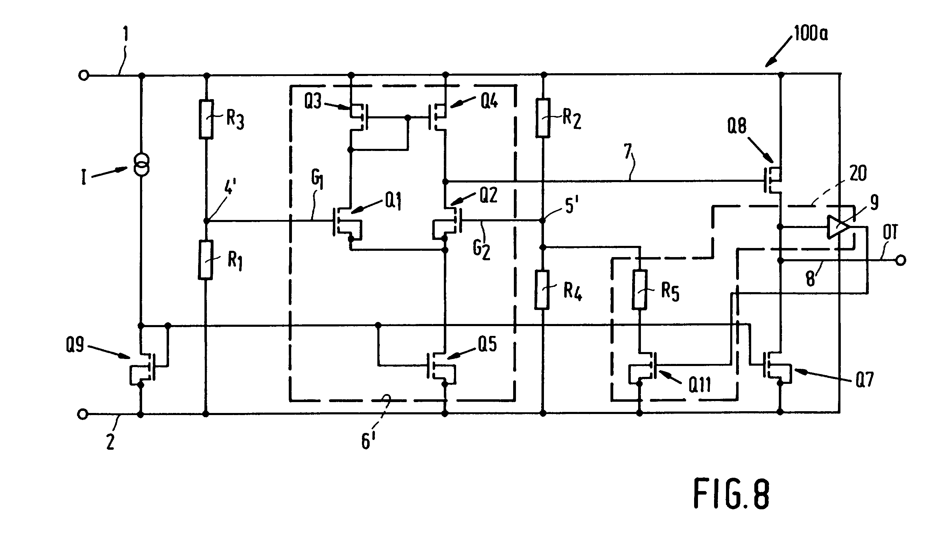

Thus, because the temperature coefficient of resistance $\alpha$ changes with absolute temperature such that the relative temperature coefficient of resistance remains substantially constant, the sensitivity to temperature of a temperature sensing device in accordance with the invention is substantially independent of temperature, more accurate temperature sensing should be possible. Such a temperature sensing device is of particular advantage in a temperature sensing circuit such as the ones 100,100a, to be described below with reference to Figures 4 and 8 in which at least one temperature sensing device R1,R2 is provided at a first position P1 adjacent an active semiconductor device 11 whose temperature is to be sensed and at least one other temperature sensing device R3,R4 is provided at a second position P2 remote from the active semiconductor device 11 and means 6 responsive to the first and second temperature sensing devices R1,R2 and R3,R4 provide a control signal to switch off the active semiconductor device 11 when the difference in the temperature sensed by the at least two temperature sensing devices R1,R2 and R3,R4 exceeds a predetermined value, that is exceeds a critical differential temperature $\Delta Tc$.

In certain conditions in active semiconductor devices such as power MOSFETs, for example, where a low resistance (say about 100m$\Omega$), load is connected between ground and the active semiconductor device, the temperature at the centre of the active semiconductor device rises much more quickly than that of the surrounding semiconductor body so that a steep temperature gradient occurs at the periphery 12 of the active semiconductor device 11. A temperature sensing circuit in accordance with the invention allows this steep temperature gradient to be detected and to be used to provide a signal to switch off the active semiconductor device before it overheats significantly. Accordingly, excessive temperatures can be detected quickly and the circuit can be particularly sensitive to temperature changes.

Furthermore, because the temperature sensing devices R1 to R4 in accordance with the invention have an effective temperature coefficient of resistance which actually changes with temperature so that their relative temperature coefficient of resistance remains substantially constant, the predetermined value or differential temperature should remain substantially constant regardless of the initial absolute temperature and accordingly the circuit 100,100a will maintain a substantially constant sensitivity to differential temperature regardless of the actual temperatures sensed.

Referring now specifically to the examples shown in the Figures, Figure 1 is a cross-sectional view through part of the semiconductor body 10. In this example, the semiconductor body 10 comprises a lowly doped (the doping concentration may be in the area typically used for the drain drift regions of vertical power MOSFETs) epitaxially grown layer of n conductivity type silicon 13 which may be provided (not shown in Figure 1) on a more highly doped monocrystalline silicon substrate. The epitaxial layer 13 forms the first region. The second region 14 is formed as a planar region by introducing, using an appropriate mask, p conductivity type impurities, generally boron ions with a dose (which determines the surface concentrations) in the region $10 \times 10^{12}$ to $13 \times 10^{12}$ atoms cm$^{-2}$, while the third region 15 is formed as a planar region within the second region 14 by introducing impurities using an appropriate mask with a dose in the region of $2 \times 10^{12}$ to $3 \times 10^{12}$ atoms cm$^{-2}$. An insulating layer, generally of silicon dioxide and typically 1.8$\mu$m thick, 19 is provided on the one major surface 10a and after opening contact windows metallisation is deposited to provide the first and second electrodes 16 and 17 and the reference electrode 18.

As indicated in phantom lines (and shown unhatched in the interests of clarity) in Figure 1, the metallisation forming the electrodes 16,17 and 18 may be patterned to define an electrostatic shield 20 which may be connected to an appropriate potential or may be electrically isolated or floating. The electrostatic shield 20 may, as shown, be formed with a break 21 in the area over the third region 15 (i.e. between the electrodes 16 and 17). The resistance of the resistor may be fine-tuned by biasing the ends of the resistor differently and by adjusting the location of the break 21 (that is by moving it closer to one or other of the electrodes 16 and 17).

Figures 2 and 3 illustrate graphically the measured relationships (indicated by dot points) between the temperature coefficient of resistance and temperature for three different devices with various different doses of arsenic and boron. Figure 2 plots the normalised temperature coefficient $\alpha_n$ of resistance against temperature in degrees Celsius where the temperature coefficient $\alpha$ is normalised by division by the temperature coefficient $\alpha$ at 27° that is so that the temperature coefficient $\alpha$ at 27° = 1. Figure 3 plots the temperature coefficient normalised to each temperature interval against temperature T in degrees Celsius (°C). Effectively Figure 3 plots the temperature coefficient at a given temperature normalised with respect to that at the preceding temperature and so indicates the percentage change $\Delta\alpha/\alpha$ in the temperature coefficient. As will be appreciated Figure 3 thus indicates the slope $\Delta\alpha$ at selected points of the graph of the temperature coefficient against temperature T. More accurate results may be obtained by using smaller temperature intervals and so getting closer to a mathematical differentiation of the $\alpha$ against T curve. However Figure 3 does serve to indicate at least roughly the percentage change in the temperature coefficient $\alpha$ as a function of temperature.

In Figures 2 and 3 the actual measurement parts are indicated by dots while the respective lines a,a', b, b', c,c' merely connect together the measurement points for the source device.

Solid lines a,a' illustrate the relationship for a temperature sensing device Rx where the second region 14 is formed by introducing boron ions to provide a surface concentration (i.e. the dose of the implantation) of 13 x $10^{12}$ atoms cm$^{-2}$ and the third region 15 is formed by introducing arsenic ions to provide a surface concentration of 2.7 x $10^{12}$ atoms cm$^{-2}$ with the device having a resistance at 27°C of 175 Kilo-ohms. The dashed lines b,b' in Figures 2 and 3 indicate the relationship for a device Rx where the second region 14 has a surface impurity concentration of 11 x $10^{12}$ atoms cm$^{-2}$ and the third region 15 has a surface concentration of 2.7 x $10^{12}$ atoms cm$^{-2}$ and a resistance at 27°C of 141 Kilo-ohms whilst the dotted lines c,c' indicate a device Rx in which the second region 14 has a surface concentration of 13 x $10^{12}$ atoms cm$^{-2}$ and the third region 15 has a surface concentration of 2.3 x $10^{12}$ atoms cm$^{-2}$ with the resistance at 27°C being 238 Kilo-ohms. In each case the measurements were made with the reference electrode 18 at 0 volts (earthed or grounded) and 5 volts between the first and second electrodes 16 and 17. The last mentioned device electrodes 16 and 17. The last mentioned device illustrated by lines c and c' had the lowest pinch-off voltage and, at 5 volts, displayed the most significant JFET like effects.

As can be seen from Figures 2 and 3, the change with temperature T of the temperature coefficient $\alpha$ that is the slope $\Delta\alpha/\Delta T$ for these devices is very small so that the relative temperature coefficient, referred to the measurement temperature, is virtually constant. It is believed that this results from the interaction of the temperature dependence of the resistance of the third region 15 and that of the JFET-like structure formed by the second and third regions 14 and 15.

To give a specific example of a resistor in accordance with the invention, where the epitaxial layer 13 is about 5µm (micrometres) in thickness and has a resistivity which enables it to withstand a voltage of about 60V, then the second and third regions 14 and 15 may be formed by implanting first boron ions at a does of 2.3 x $10^{12}$ ions cm$^{-2}$ with an energy of 170KeV (Kiloelectron volts) and then arsenic ions at a dose of 1.3 x $10^{13}$ ions cm$^{-2}$ with an energy of 170KeV through a thin (generally 300Å) oxide layer such that the peak of the boron implant lies at about 0.5µm (micrometres) below the surface of the semiconductor body 10. The implanted impurities are then caused to diffuse into the semiconductor body 10 by heating the semiconductor body 10 to a temperature of about 1100°C (degrees Celsius) for about four hours so that the second region 14 has a depth of about 2µm (with its peak dopant concentration just below the surface) and the third region 15 has a depth of about 0.3 to 0.4µm. A region forming using the same conditions as those described above for the second region 14 but without the third region 15 was found to have a resistance of 5k$\Omega$. $\square^{-1}$ (Kiloohms per square) and a temperature coefficient of resistance, referenced to room temperature, which changed by 0.7 or 0.8% per °C. In contrast, the resistor (complete with the third region 15 formed within the second region 14) was found to have a resistance (in the third region 15) of 10k$\Omega$. $\square^{-1}$ and a differential temperature coefficient of resistance $\Delta\alpha/\alpha$ referenced to the preceding temperature which changed by 0.4% per °C so that the temperature coefficient with respect to room temperature was actually falling slightly.

Figure 4 illustrates one example of a temperature sensing circuit 100 utilising temperature sensing device Rx in accordance with the invention. In this example four such temperature sensing devices R1,R2,R3 and R4 are used.

The temperature sensing circuit 100 has first and second power supply lines 1 and 2. The first power supply line 1 is the positive and the second power supply line 2 the negative supply line, generally earth in this example.

In this example, four temperature sensing devices Rx which are shown as resistors R1 to R4 are arranged in a Wheatstone bridge connected between the power supply lines 1 and 2. The first and second resistors R1 and R2 are provided in opposite arms of the Wheatstone bridge. The third and first resistors R3 and R1 are connected in series between the power supply lines 1 and 2 as are the second and fourth resistors R2 and R4 so that, as shown in Figure 4, the second and third resistors R2 and R3 are connected to the first or positive supply line 1 whilst the first and fourth resistors R1 and R4 are connected to the second or negative supply line 2.

In the circuit shown in Figure 4, a first n-channel MOSFET Q12 is connected in series between the resistors R2 and R4 so that its source is connected to resistor R4 and its drain to resistor R2. A second n-channel MOSFET Q13 matched or similar to MOSFET Q12 is connected between the resistors R3 and R1 with its source connected to the resistor R1 and its drain connected to the resistor R3.

The gates of the two MOSFETs Q12 and Q13 are connected together at a node 13 and the gate of the MOSFET Q12 is connected to its drain at node 4. The node 4 is also connected to one input of a comparator 6 while a node 5 between the resistor R3 and the drain of MOSFET Q13 is connected to the other input of the comparator 6. The comparator 6 may have any suitable form although it is preferred that the use of p-channel MOSFETs and bipolar transistors be avoided.

The operation of the circuit shown in Figure 4 will now be described assuming, in the interests of simplicity, that the gain of the MOSFETs Q12 and Q13 is very high so that their gate-source voltage Vgs is nearly constant. When the resistors R1 to R4 are all at the same temperature R3 = KR2 and R4 = KR1 with K being, for example, about 1.1. If the current through resistor R2, MOSFET Q12 and resistor R4 is defined as I' the current I'' flowing through resistor R1 is approximately (R4/R1) I' = KI'. The voltage across resistor R2 is I'R2. The voltage across resistor R3 is I''R3 = KI'R3 = $K^2$I'R2. The difference in voltage between the nodes 4' and 5' is therefore:

$$\Delta V = I'R2(1-K^2)$$

As the temperature of the hot resistors R2 and R1 increases the value of K will decrease until K = 1 when the temperature difference between the hot resistors R2 and R1 and the cold resistors R3 and R4 reaches the critical value. At this point the difference in voltage $\Delta V$ = 0. As the temperature of the resistors R1 and R2 increases further the resistance of the resistors R1 and R2 will exceed that of the resistors R3 and R4 and the comparator 6 will provide a signal for switching off the active semiconductor device 11.

The incorporation of the current-mirror connected MOSFETs Q12 and Q13 enables a larger differential gain which results in a lower accuracy requirement for the comparator 6. The circuit 100 should have a high sensitivity than the circuit 100' described below with reference to Figure 8 and thus may be useful where the resistors R1 to R4 have a small temperature coefficient of resistance or a high noise margin which characteristics will primarily be determined by the process used to form the resistors.

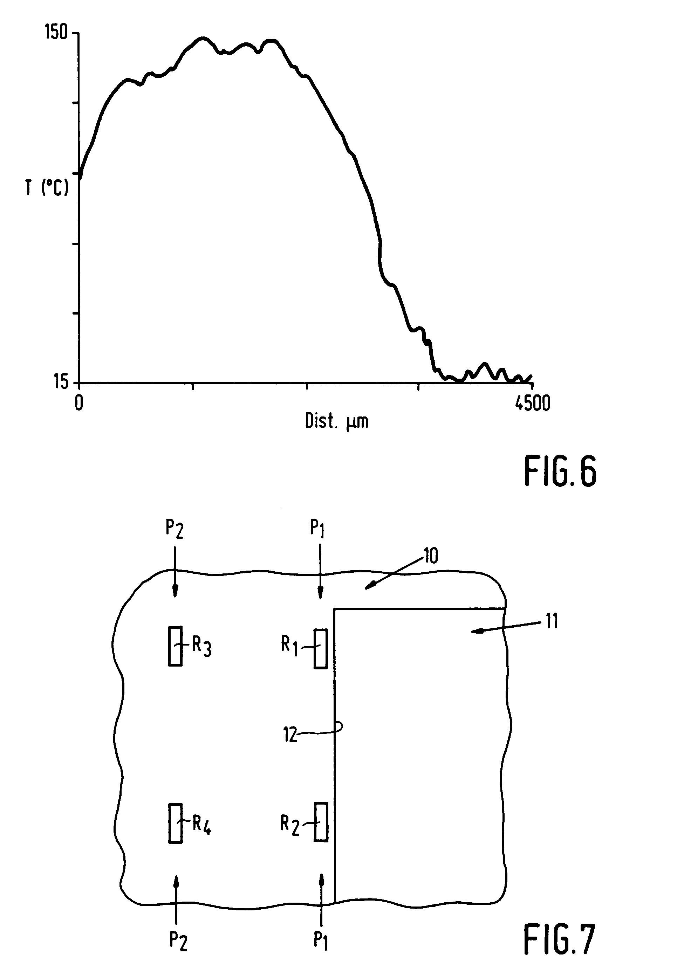

Figure 5 is a cross-sectional view of part of the semiconductor body 10 for illustrating the integration of the circuit 100 with a power semiconductor device 11 such as a power MOSFET. It will of course be appreciated that only part of the structure is shown in Figure 2. The interconnections between the various components are not shown in Figure 2.

In the example of Figure 5, the semiconductor body 10 comprises a relatively highly doped n conductivity type monocrystalline silicon substrate 10b onto which is provided the relatively lowly doped n conductivity type epitaxial layer 13. In this example the power semiconductor device is a vertical power MOSFET 11 which consists of very many (hundreds of thousands) parallel-connected source cells sharing a common drain drift region provided by the epitaxial layer 13. The relatively highly doped substrate 10b provides a drain contact region which makes ohmic contact to the drain electrode 31. Each source cell comprises a p conductivity type body region 32 within which is formed on n conductivity type source region 33. In this case, the body and source regions 32 and 33 may be formed in a self-aligned manner by using the insulated gate structure 34 of the MOSFET as a mask so as to define the conduction channel region 35 of the MOSFET by the relative diffusions of the impurities introduced to form the body and source regions 32 and 33. The body region 32 may have a more highly doped central region 32a.

In this example, the power semiconductor device 11 is to form a low side switch and accordingly the source metallisation 36 (which also shorts the source region 33 to the body region 32 to avoid parasitic bipolar action) may be connected to earth while the drain electrode 31 will be connected to the load. The gate metallisation is not shown in Figure 5.

As indicated above, each temperature sensing device R1 to R4 is formed having its own separate second region 14. As the resistors R1 to R4 are the same in structure only one resistor R1 is shown in Figure 5. However, it may be possible for the two 'hot' resistors R1 and R2 to share a common second region 14 positioned at position P1 which may as shown in Figure 7 be adjacent the periphery 12 of the active device 11 or may actually be surrounded by the power MOSFET source cells and so positioned centrally within the power MOSFET 11 which should enable a more accurate detection of the temperature at the centre of the power MOSFET 11.

The cold resistors R3 and R4 may be provided in a single second region 14 remote from the power MOSFET 11. The MOSFETs Q12 and Q13 may be formed in the same second region as the cold resistors R3 and R4. As indicated above each second region 14 is relatively lowly doped and may for example have a surface dopant concentration in the region of 11 to 13 x $10^{12}$ atoms $cm^{-2}$ where the dopant is boron.

The IGFETs Q12 and Q13 both have a similar structure and accordingly only one IGFET Q12 is shown in Figure 5. As can be seen from Figure 5, the IGFET Q2 has n conductivity type source and drain regions 40 and 41 formed in an autoaligned manner, using the insulated gate 42 as a mask, with a single implantation. The source, drain and gate metallisation S, D and G are provided in conventional manner. The back gates of MOSFETs Q12 and Q13 will in this case be connected to the negative supply line 2 by means of the reference electrode 18 contacting the second region 14.

Figure 6 illustrates graphically the change in temperature from the centre to the edge of a typical active semiconductor device such as a power MOSFET with a source-drain voltage of 21 volts and a power of dissipation of 300 watts when for example an overload of small resistance (for example about 100m$\Omega$) is applied between the power MOSFET and ground (earth).

Under such conditions where a relatively small resistance overload is so applied, the temperature at the centre of the power MOSFET will rise rapidly whereas the temperature in the bulk or remainder of the semiconductor body will rise only slowly. Accordingly, as illustrated in Figure 6, a steep temperature gradient occurs adjacent the periphery 12 of the power MOSFET. By locating the first and second temperature sensing devices R1 and R2, at a first position $P_1$ adjacent, generally just outside, the periphery 12 of the power MOSFET and the third and fourth temperature sensing devices R3 and R4, at a second position $P_2$ further from the periphery 12 of the active device 11 where the temperature is only changing slowly, if at all, the temperature gradient at the periphery of the power MOSFET can be detected and when it reaches a certain value the power MOSFET can be switched off by the circuit described with reference to Figure 1.

As indicated above, the temperature sensing circuit 100 is integrated in or on the same semiconductor body as the active device, in this example a power MOSFET. Figure 7 indicates very schematically a plan view of the top surface of the semiconductor body 10 to show the relative locations of the periphery 12 of the power MOSFET 11 and the first and second temperature sensitive devices R1 to R4. Typically, where the power MOSFET is a vertical DMOSFET having a surface area of 10mm$^2$ and consisting of, for example, 10,000 to 20,000 parallel cells, then the 'hot' temperature sensing devices R1 and R2 may be positioned at a first position $P_1$ which is 125$\mu$m distant from the MOSFET periphery 12 although as indicated above, the resistors R1 to R4 could be provided amongst the source cells of the power MOSFET 11. The 'cold' temperature sensing devices R3 and R4 may be positioned at a second position $P_2$ 1125$\mu$m distant from the periphery 12 of the power MOSFET 11 and the resistances of the temperature sensitive elements R1 to R4 may be selected such that the comparator 6 provides a high output signal resulting in a low signal OT to switch off the power MOSFET 11, when the temperature gradient between the first and second positions $P_1$ to $P_2$ reaches 25ºC. In this example, the resistors R1 and R2 may have a resistance which is, for example, 0.9 times that of the resistors R3 and R4. It should be understood that the reference to the periphery 12 of the power MOSFET means the last row of cells and that the above measurements are taken between the periphery 12 and the centre of the resistors forming the temperature sensing devices R1 to R4.

Figure 8 illustrates the circuit diagram of another form of temperature sensing circuit 100' which may be used where complementary MOS technology is easily applied and where, for example, the active semiconductor device 11 is a power MOSFET forming a high side switch that is where the MOSFET 11 is connected between the positive supply line 1 and the load.

As in the example shown in Figure 1, the circuit 100' has positive and negative supply lines 1 and 2 and uses a Wheatstone bridge arrangement comprising four temperature sensing devices or resistors R1 to R4 similar to those shown in Figures 1,4 and 7 with again the resistors R1 and R2 forming the 'hot' resistors at position P1 and the resistors R3 and R4 forming the cold resistors at position P2. In this example the MOSFETs Q12 and Q13 are omitted.

The outputs from the Wheatstone bridge are taken from a first junction 4' between the third and first resistors R3 and R1 and a second junction 5' between the second and fourth resistors R2 and R4 and are supplied as respective inputs to a comparator 6' which provides a control signal to switch off the active semiconductor device 11 when the voltage at the first junction 4' exceeds the voltage at the second junction 5'.

In this example, the resistors R1 to R4 are selected such that when all four resistors R1 to R4 are at the same temperature the 'hot' first and second resistors R1 and R2 are of lower resistance than the third and fourth resistors R3 and R4. Thus, when there is no temperature difference between the first and second temperature sensitive devices R1,R2 and R3,R4, the voltage at the second junction 5' is higher than the voltage at the first junction 4' and the Wheatstone bridge does not reach a balance (that is the point at which the voltages at the first and second junctions 4' and 5' are equal) until the temperature of the first and second resistors R1 and R2 has increased sufficiently for their resistances to equal the resistances of the resistors R3 and R4.

By selecting the relative values of the temperature sensing devices or resistors R1,R2 and R3,R4, the temperature gradient between the first and second temperature sensing devices R1,R2 and R3,R4 at which the comparator 6' provides a control signal to switch off the active device 11 can be selected. The respective values of the resistors R1 and R2 and the resistors R3 and R4 will be dependent upon many variables such as the characteristics of the resistors and other elements of the circuit and the respective distances of the resistors from the periphery 12 of the active semiconductor device 11. In this example, the resistance of the resistors R1 and R2 increases with temperature in such a manner that a balance is reached when there is a temperature difference of, for the values given above, 25ºC between the first and second temperature sensing devices. Any temperature difference exceeding this value will cause the active semiconductor device to be switched off.

In the circuit shown in Figure 8, the comparator 6' comprises a differential pair of matched transistors Q1 and Q2 which form the input transistors of the comparator 6'. In this example, the transistors Q1 and Q2 are n-channel MOSFETs with their gates G1 and G2 connected to the first and second junctions 4' and 5', respectively. The comparator 6' also includes two p-channel matched MOSFETs Q3 and Q4 having their source electrodes connected to the first supply line 1. The gate electrodes of the MOSFETs Q3 and Q4 are connected whilst the gate electrode of MOSFET Q3 is also connected to its drain. The MOSFETs Q3 and Q4 thus provide a current mirror arrangement and with their drain electrodes connected to respective ones of the drain electrodes of the MOSFETs Q1 and Q2 provide an active load for the differential pair Q1 and Q2.

The sources of the MOSFETs Q1 and Q2 are connected to the drain of an n-channel MOSFET Q5. The source of the MOSFET Q5 is connected to the second or negative supply line 2 whilst its gate is connected to the gate of a gate-drain connected n-channel MOSFET Q9 which is connected in series with a conventional current source I which may, in this example, be a resistor (typically with a resistance of 200 Kilo-ohms) connected between the supply lines 1 and 2 because, in this example, the voltages on the supply lines 1 and 2 are fixed. Alternatively, a suitable conventional external current source may be connected between the supply lines 1 and 2. The current source I forces current into MOSFET Q9 and this current is mirrored in MOSFET Q5 which thus acts as a current source of a value determined by the external current source I for the differential amplifier comparator 6'. Other suitable structures may, of course, be used to form the comparator 6'.

The output 7 of the comparator 6' is supplied to the gate of a p-channel MOSFET Q8 which has its source connected to the first supply line 1 and its drain connected via an n-channel MOSFET Q7 to the second supply line 2. The gate of the n-channel MOSFET Q7 is, like that of MOSFET Q5, connected to the external current source I and thus similarly acts as a current source of a value determined by the external current source I. The MOSFETs Q9,Q5 and Q7 are integrated together so as to be similar. It should be understood that, as used herein, the term 'similar' means that the devices, for example transistors, are integrated together so as to be matched or else so as to have a known ratio of effective junction areas so that the current I provided by the current source through the MOSFET Q9 is mirrored in the MOSFETs Q5 and Q7 with the currents through Q5 and Q7 being either equal to (where the transistors are matched) or a known multiple of the current through the MOSFET Q9. With appropriate modification of component values, it may be possible for the MOSFETs Q1 and Q2 and Q3 and Q4 forming the comparator 6' to have known ratios of effective junction areas rather than be precisely matched. The drain of the p-channel MOSFET Q8 provides, via line 8, the control signal OT for controlling the operation of the active semiconductor device 11 (Figure 3). In addition the drain of p-channel MOSFET Q8 is connected to a NOT gate 9 in the form of an inverter which drives the gate of an n-channel enhancement mode MOSFET Q11. The n-channel MOSFET Q11 is connected in series with a resistor R5 and the series circuit of the n-channel MOSFET Q11 and resistor R5 is connected in parallel with the fourth temperature sensing device R4.

Resistor R5, MOSFET Q11 and inverter or NOT gate 9 provide a hysteresis circuit 20. Thus, when the signal on the output 7 of the comparator 6 is high providing a low output signal OT from the MOSFET Q8 for turning off the active device 11, the NOT gate 9 provides a high input signal to switch on the MOSFET Q11, so connecting the resistor R5 in parallel with the fourth temperature sensing device R4. This reduces the effective resistance of the fourth temperature sensing device R4 so that the temperature of the first and second heat sensitive devices R1 and R2 has to drop to a second predetermined value, typically 20°C (degrees Celsius), below the predetermined value before the output of the comparator 6' again goes low to provide a high signal OT to switch on the active device 11. This hysteresis circuit 20 prevents the temperature sensing circuit 100 hunting or cycling, that is continually causing the active semiconductor device to switch on and off, with small temperature changes.

In operation of the temperature sensing circuit 100 shown in Figure 8 when there is no temperature difference between the resistors R1 to R4, then the voltage at the second junction 5' will be higher than that at the first junction 4' because, as discussed above, of the ratio of the resistances, so that the comparator 6 provides a low output on output line 7. The MOSFET Q8 is thus on and the output signal OT is high. As the temperature of the resistors R1 and R2 increases so does their resistance and at a temperature selected by the ratio of the ratio of the resistors the bridge will come into balance. As the temperature of the resistors R1 and R2 increases further the resistance of the temperature sensitive devices R1 and R2 will be greater than the resistance of the temperature sensitive devices R3 and R4, so causing the voltage at the first junction 4' to exceed that at the second junction 5'. Typically, this will be arranged to occur when there is a large, typically 25°C, temperature difference between the first and second positions $P_1$ and $P_2$. In such circumstances, the comparator 6' produces a high output signal on output line 7 to the gate of p-channel MOSFET Q8 so that the MOSFET Q8 is off and the circuit 100 provides a low output signal OT for switching off the active device in this case the power MOSFET 11 shown schematically in Figures 5 and 7. As mentioned above, at this time, the NOT gate 9 provides a high signal to switch on the MOSFET Q11 so connecting the resistor R5 in parallel with the fourth temperature sensing device R4.

As the power MOSFET 11 has now been switched off, the temperature difference between the first and second positions $P_1$ and $P_2$ will begin to decrease and when this temperature difference drops sufficiently, to reach the second lower predetermined value determined by the resistor R5, the voltage at the second junction 5' will rise above that at the first junction 4' causing the comparator 6' to provide a low output signal to the gate of the MOSFET Q8, so switching on the MOSFET Q8 and providing a high output signal OT to switch on the active device 11. At the same time, the inverter or NOT gate 9 provides a low signal switching off the MOSFET Q11 and so disconnecting the resistor R5 so that the comparator 6' will again provide a high output signal for switching off the active device 11 when the first higher predetermined temperature difference is reached.

It should of course be appreciated that temperature sensing devices in accordance with the invention may be used in temperature sensing circuits other than those shown in Figures 4 and 8, for example to form the resistor R1 of the temperature sensing circuit described in EP-A-369530.

In addition, of course the conductivity type, given above could be reversed with appropriate reversal of polarities. Also the active semiconductor device 11 may be other than a power MOSFET, for example it could be an IGBT.

From reading the present disclosure, other modifications and variations will be apparent to persons skilled in the art. Such modifications and variations may involve other features which are already known in the semiconductor art and which may be used instead of or in addition to features already described herein.

It has been stated above that the drawings illustrate examples of embodiments of the invention and, in order to avoid any misunderstanding, it is hereby further stated that, in the following claims, where technical features mentioned in any claim are followed by reference signs relating to features in the drawings and placed between parentheses, these reference signs have been included in accordance with Rule 29(7) EPC for the sole purpose of facilitating comprehension of the claim, by reference to an example.

**Claims**

1. A temperature sensing device comprising a semiconductor body (10) having a first region (13) of one conductivity type adjacent one major surface (10a) within which is formed a semiconductor device (RX) having a resistance which varies with temperature, characterised in that the semiconductor device comprises a second region (14) of the opposite conductivity type formed within the first region (13) and a third region (15) of the one conductivity type formed within the second region, first and second electrodes (16, 17) spaced-apart on the third region (15) so that a resistive path is provided by the third region (15) between the first and second electrodes (16,17) and a reference electrode (18) for connecting the second region (14) to a reference potential, the impurity concentrations within the second and third regions (14,15) being such that the temperature coefficient of resistance changes with absolute temperature so that the relative temperature coefficient of resistance, $\alpha$ referred to the sensed temperature is substantially constant.

2. A temperature sensing device according to claim 1, wherein the second region (14) has a surface impurity concentration in the region of 10 to 13 x $10^{12}$ atoms $cm^{-2}$ and the third region (15) has a surface impurity concentration in the region of 2 to 3 x $10^{12}$ atoms $cm^{-2}$.

3. A temperature sensing device according to claim 2, wherein the second region (14) has a surface impurity concentration of 13 x $10^{12}$ atoms $cm^{-2}$ and the third region (15) has a surface impurity concentration of 2.7 x 1012 atoms $cm^{-2}$, the second region (14) having a depth of about 2$\mu$m and the third region (15) having a depth in the region of 0.3 to 0.4$\mu$m.

4. A temperature sensing circuit for sensing the temperature of an active semiconductor device which circuit comprises at least one temperature sensing device in accordance with Claim 1,2 or 3 provided at a first position (P1) adjacent the active semiconductor device (11), at least one other temperature sensing device in accordance with Claim 1,2 or 3 provided at a second position (P2) remote from the active semiconductor device (11) and means (6) responsive to the temperature sensing devices for providing a control signal to switch off the active semiconductor device when the difference in the temperatures sensed by the at least two temperature sensing devices exceeds a predetermined value.

5. A temperature sensing circuit for sensing the temperature of an active semiconductor device (11) comprising first and second temperature sensing devices in accordance with Claim 1,2 or 3 at a first position (P1) adjacent the active semiconductor device and third and fourth temperature sensing devices in accordance with Claim 1,2 or 3 at a second position (P2) remote from the active semiconductor device (11), the temperature sensing devices being connected in a Wheatstone bridge with the first (R1) and third (R3) devices and the second (R2) and fourth (R4) devices, respectively, connected in series between first and second supply lines (1,2) and with the second and third devices (R2,R3) connected to the first supply line (1) and the means (6) for comparing a first signal representing the voltage at a first junction (5) between the third and first devices (R3,R1) and a second signal representing the voltage at a second junction (4) between the second and fourth devices (R2,R4) and for providing an output signal which provides the control signal to switch off the active semiconductor device when the difference between the first and second voltage signals represents a temperature difference of the predetermined value.

6. A temperature sensing circuit according to claim 5, further comprising a transistor (Q13) having its main current path connected between the first junction (5) and the first temperature sensing device (R1) and another transistor (Q12) having its main current path connected between the second junction (4) and the fourth temperature sensing device (R4) with the gates of the transistors being connected to one another and to one of the first and second junctions.

7. A temperature sensing circuit according to claim 5 or 6, wherein the comparing means (6') comprises first and second transistors (Q1,Q2) having control gates connected to the first and second junction (4', 5'), respectively, a current mirror arrangement (Q3,Q4) connected between the first supply (1) line and one main electrode of each of the first and second transistors (Q1,Q2) and current source means connected to the other main electrode of each of the first and second transistors, the control signal being supplied via an output connection from the one main electrode of the second transistor.

8. A temperature sensing circuit according to claim 5,6 or 7, wherein a resistances (R5) in series with switch means (20) is provided across the fourth temperature sensing device (R4) with the switch means being controlled by the output signal (7) of the comparing means (6') to connect the resistance (R5) parallel with the fourth temperature sensing device (R4) when the temperature difference exceeds the predetermined value for preventing the active semiconductor device from being switched on again until the temperature difference has fallen to a second predetermined value below the predetermined value.

9. A temperature sensing circuit according to any one of claims 4 to 8, wherein the active semiconductor device (11) comprises a power insulated gate field effect device integrated in the same semiconductor body as the temperature sensing devices.

10. An integrated circuit (10,11) whenever incorporating at least one temperature sensing device (10) in accordance with Claim 1,2 or 3.

**Patentansprüche**

1. Temperaturfühlvorrichtung mit einem Halbleiterkörper (10), welcher eine erste Zone (13) des einen Leitfähigkeitstyps in Angrenzung an eine Hauptoberfläche (10a) aufweist, innerhalb welcher eine Halbleiteranordnung (RX) mit einem sich mit der Temperatur verändernden Widerstand ausgebildet ist, *dadurch gekennzeichnet*, daß die Halbleiteranordnung eine in der ersten Zone (13) ausgebildete, zweite Zone (14) des entgegengesetzten Leitfähigkeitstyps sowie eine in der zweiten Zone ausgebildete, dritte Zone (15) des einen Leitfähigkeitstyps, eine erste und eine zweite Elektrode (16,17) auf der dritten Zone (15) so voneinander beabstandet aufweist, daß durch die dritte Zone (15) zwischen der ersten und zweiten Elektrode (16,17) und einer Bezugselektrode (18) eine Widerstandsbahn zum Anschluß der zweiten Zone (14) an ein Bezugspotential vorgesehen ist, wobei die Störstellenkonzentrationen innerhalb der zweiten und dritten Zone (14,15) so hoch sind, daß sich der Widerstands-Temperaturkoeffizient bei absoluter Temperatur verändert, so daß der relative Widerstands-Temperaturkoeffizient $\alpha$, bezogen auf die gemessene Temperatur, im wesentlichen konstant ist.

2. Temperaturfühlvorrichtung nach Anspruch 1, bei welcher die zweite Zone (14) eine Oberflächenstörstellenkonzentration im Bereich von 10 bis 13 x $10^{12}$ Atomen cm$^{-2}$ und die dritte Zone (15) eine Oberflächenstörstellenkonzentration im Bereich von 2 bis 3 x $10^{12}$ Atomen cm$^{-2}$ aufweist.

3. Temperaturfühlvorrichtung nach Anspruch 2, bei welcher die zweite Zone (14) eine Obertlächenstörstellenkonzentration von 13 x $10^{12}$ Atomen cm$^{-2}$ und die dritte Zone (15) eine Oberflächenstörstellenkonzentration von 2,7 x $10^{12}$ Atomen cm$^{-2}$ aufweist, wobei die zweite Zone (14) eine Tiefe von etwa 2μm und die dritte Zone (15) eine Tiefe im Bereich von 0,3 bis 0,4μm aufweisen kann.

4. Temperaturfühlschaltung zum Messen der Temperatur einer aktiven Halbleiteranordnung, welche zumindest eine an einer ersten Position (1) in Angrenzung an die aktive Halbleiteranordnung (11) vorgesehene Temperaturfühlvorrichtung nach Anspruch 1,2 oder 3, zumindest eine an einer zweiten Position (P2), von der aktiven Halbleiteranordnung (11) entfernt vorgesehene, weitere Temperaturfühlvorrichtung nach Anspruch 1,2 oder 3 sowie eine auf die Temperaturfühlvorrichtung ansprechende Vorrichtung (6), welche ein Steuersignal vorsieht, um die aktive Halbleiteranordnung abzuschalten, wenn der von mindestens zwei Temperaturfühlvorrichtungen gemessene Temperaturunterschied einen vorgegebenen Wert überschreitet, aufweist.

5. Temperaturfühlschaltung zum Messen der Temperatur einer aktiven Halbleiteranordnung (11), welche eine erste und eine zweite Temperaturfühlvorrichtung nach Anspruch 1,2 oder 3 an einer ersten Position (P1) in Angrenzung an die aktive Halbleiteranordnung und eine dritte und vierte Temperaturfühlvorrichtung nach Anspruch 1,2 oder 3 an einer zweiten Position (P2) von der aktiven Halbleiteranordnung (11) weiter entfernt aufweist, wobei die Temperaturfühlvorrichtungen in einer Wheatstone-Brücke angeschlossen und dabei die erste (R1) und dritte Anordnung (R3) beziehungsweise die zweite (R2) und vierte Anordnung (R4) zwischen der ersten und zweiten Versorgungsleitung (1,2) in Reihe geschaltet und die zweite und dritte Anordnung (R2,R3) an die erste Versorgungsleitung (1) und die Vorrichtung (6) zum Vergleichen eines die Spannung an einem ersten Übergang (5) zwischen der dritten und ersten Vorrichtung (R3,R1) darstellenden, ersten Signales und eines die Spannung an einem zweiten Übergang (4) zwischen der zweiten und vierten Vorrichtung (R2,R4) darstellenden, zweiten Signales sowie zur Auslösung eines Ausgangssignales, welches das Steuersignal zum Abschalten der aktiven Halbleiteranordnung vorsieht, sobald die Differenz zwischen dem ersten und zweiten Spannungssignal eine Temperaturdifferenz des vorgegebenen Wertes darstellt, angeschlossen sind.

6. Temperaturfühlschaltung nach Anspruch 5, welche ferner einen Transistor (Q13) mit einer zwischen dem ersten Übergang (5) und der ersten Temperaturfühlvorrichtung (R1) angeschlossenen Hauptstrombahn sowie einen weiteren Transistor (Q12) mit einer zwischen dem zweiten Übergang (4) und der vierten Temperaturfühlvorrichtung (R4) angeschlossenen Hauptstrombahn aufweist, wobei die Gate-Elektroden der Transistoren miteinander und mit einem ersten und zweiten Übergang verbunden sind.

7. Temperaturfühlschaltung nach Anspruch 5 oder 6, bei welcher die Vergleichsvorrichtung (6') einen ersten und zweiten Transistor (Q1,Q2) mit an den ersten bzw. zweiten Übergang (4',5') angeschlossenen Steuer-Gates eine zwischen der ersten Versorgungsleitung (1) und einer Hauptelektrode jedes ersten und zweiten Transistors (Q1,Q2) geschalteten Stromspiegelanordnung (Q3,Q4) sowie eine an die weitere Hauptelektrode jedes ersten und zweiten Transistors angeschlossene Stromquelle aufweist, wobei das Steuersignal über eine Ausgangsverbindung von der einen Hauptelektrode des zweiten Transistors übermittelt wird.

8. Temperaturfühlschaltung nach Anspruch 5,6 oder 7, bei welcher ein Widerstand (Q5) in Reihe mit einer Schaltvorrichtung (20) an die vierte Temperaturfühlvorrichtung (R4) angelegt wird, wobei die Schaltvorrichtung von dem Ausgangssignal (7) der Vergleichsvorrichtung (6') gesteuert wird, um den Widerstand (R5) mit der vierten Temperaturfühlvorrichtung (R4) parallelzuschalten, wenn die Temperaturdifferenz den vorgegebenen Wert überschreitet, und ein erneutes Einschalten der aktiven Halbleiteranordnung zu verhindern, bis die Temperaturdifferenz auf einen zweiten, vorgegebenen Wert unter dem festgelegten Wert gefallen ist.

9. Temperaturfühlschaltung nach einem der Ansprüche 4 bis 8, bei welcher die aktive Halbleiteranordnung (11) ein in den gleichen Halbleiterkörper wie die Temperaturfühlvorrichtungen integriertes Leistungsfeldeffektbauelement mit isolierter Gate-Elektrode aufweist.

10. Integrierte Schaltung (10,11) bei Einbau von zumindest einer Temperaturfühlvorrichtung (10) nach Anspruch 1,2 oder 3.

## Revendications

1. Dispositif détecteur de température comprenant un corps de semi-conducteur (10) comportant une première région (13) d'un premier type de conductivité, adjacente à une surface principale (10a) dans laquelle est formé un dispositif à semi-conducteur (RX) dont la résistance varie avec la température, caractérisé en ce que le dispositif à semi-conducteur comprend une deuxième région (14) du type de conductivité opposé formée dans la première région (13) et une troisième région (15) du premier type de conductivité formée dans la deuxième région, une première et une deuxième électrodes (16, 17) distantes l'une de l'autre sur la troisième région (15), de sorte qu'un chemin résistif est offert par la troisième région (15) entre la première et la deuxième électrodes (16, 17) et une électrode de référence (18) permettant de connecter la deuxième région (14) à un potentiel de référence, les concentrations d'impuretés dans les deuxième et troisième régions (14, 15) étant telles que le coefficient de température de résistance varie avec la température absolue de telle sorte que le coefficient de température relative de résistance, $\alpha$, rattaché à la température détectée soit essentiellement constant.

2. Dispositif détecteur de température suivant la revendication 1, dans lequel la deuxième région (14) a une concentration d'impuretés surfacique de l'ordre de 10 à 13 x $10^{12}$ atomes cm$^{-2}$ et la troisième région (15) a une concentration d'impuretés surfacique de l'ordre de 2 à 3 x $10^{12}$ atomes cm$^{-2}$.

3. Dispositif détecteur de température suivant la revendication 2, dans lequel la deuxième région (14) a une concentration d'impuretés surfacique de 13 x $10^{12}$ atomes cm$^{-2}$ et la troisième région (15) a une concentration d'impuretés surfacique de 2,7 x $10^{12}$

atomes cm$^{-2}$, la deuxième région (14) ayant une épaisseur d'environ 2 μm et la troisième région (15) ayant une épaisseur de l'ordre de 0,3 à 0,4 μm.

4. Circuit détecteur de température destiné à détecter la température d'un dispositif à semi-conducteur actif, lequel circuit comprend au moins un dispositif détecteur de température conforme à la revendication 1, 2 ou 3, prévu à un premier endroit (P1) adjacent au dispositif à semi-conducteur actif (11), au moins un autre dispositif détecteur de température conforme à la revendication 1, 2 ou 3, prévu à un deuxième endroit (P2) distant du dispositif à semi-conducteur actif (11) et un moyen (6) sensible aux dispositifs détecteurs de température destiné à délivrer un signal de commande afin de bloquer le dispositif à semi-conducteur actif lorsque la différence de température détectée par les au moins deux dispositifs détecteurs de température dépasse une valeur prédéterminée.

5. Circuit détecteur de température destiné à détecter la température d'un dispositif à semi-conducteur actif (11) comprenant un premier et un deuxième dispositifs détecteurs de température suivant la revendication 1, 2 ou 3, à un premier endroit (P1) adjacent au dispositif à semi-conducteur actif et un troisième et un quatrième dispositifs détecteurs de température conformes à la revendication 1, 2 ou 3, à un deuxième endroit (P2) distant du dispositif à semi-conducteur actif (11), les dispositifs détecteurs de température étant connectés dans un pont de Wheatstone dans lequel les premier (R1) et troisième (R3) dispositifs et les deuxième (R2) et quatrième (R4) dispositifs, respectivement, sont connectés en série entre les première et deuxième lignes d'alimentation (1, 2) et les deuxième et troisième dispositifs (R2, R3) sont connectés à la première ligne d'alimentation (1) et le moyen (6) destiné à comparer un premier signal représentant la tension à une première jonction (5) entre les troisième et premier dispositifs (R3, R1) et un deuxième signal représentant la tension à une deuxième jonction (4) entre les deuxième et quatrième dispositifs (R2, R4) et destiné à délivrer un signal de sortie qui donne le signal de commande pour bloquer le dispositif à semi-conducteur actif lorsque la différence entre les premier et deuxième signaux de tension représente une différence de température de la valeur prédéterminée.

6. Circuit détecteur de température suivant la revendication 5, comprenant en outre un transistor (Q13) dont le chemin principal du courant est connecté entre la première jonction (5) et le premier dispositif détecteur de température (R1) et un autre transistor (Q12) dont le chemin principal du courant est connecté entre la deuxième jonction (4) et le quatrième dispositif détecteur de température (R4), les grilles des transistors étant connectées l'une à l'autre et à l'une des première et deuxième jonctions.

7. Circuit détecteur de température suivant la revendication 5 ou 6, dans lequel le moyen comparateur (6') comprend un premier et un deuxième transistors (Q1, Q2) dont les grilles de commande sont connectées à la première et à la deuxième jonctions (4', 5'), respectivement, un montage en miroir de courant (Q3, Q4) connecté entre la première ligne d'alimentation (1) et une électrode principale de chacun des premier et deuxième transistors (Q1, Q2) et une source de courant connectée à l'autre électrode principale de chacun des premier et deuxième transistors, le signal de commande étant fourni via une connexion de sortie par la première électrode principale du deuxième transistor.

8. Circuit détecteur de température suivant la revendication 5, 6 ou 7, dans lequel une résistance (R5) en série avec un moyen commutateur (20) est prévue aux bornes du quatrième dispositif détecteur de température (R4), le moyen commutateur étant commandé par le signal de sortie (7) du moyen comparateur (6') pour connecter la résistance (R5) en parallèle avec le quatrième dispositif détecteur de température (R4) lorsque la différence de température dépasse la valeur prédéterminée afin d'empêcher au dispositif à semi-conducteur actif de se débloquer à nouveau jusqu'à ce que la différence de température soit tombée à une deuxième valeur prédéterminée inférieure à la valeur prédéterminée.

9. Circuit détecteur de température suivant l'une quelconque des revendications 4 à 8, dans lequel le dispositif à semi-conducteur actif (11) comprend un dispositif à effet de champ à grille isolée de puissance intégré dans le même corps de semi-conducteur que les dispositifs détecteurs de température.

10. Circuit intégré (10, 11) incorporant au moins un dispositif détecteur de température (10) conforme à la revendication 1, 2 ou 3.

FIG.1

FIG.2

FIG.3

FIG.4

FIG.5

**FIG.6**

**FIG.7**

FIG.8

EP 0 523 798 B1